# EUROPEAN PATENT APPLICATION

(11) **EP 3 473 979 A1**
(43) Date of publication of application: **24.04.2019**
(21) Application number: 16906106.6
(22) Date of filing: 25.10.2016
(51) Int. Cl.: G01C 17/38

(54) **ANTI-CHARGING GEOMAGNETIC INTERFERENCE METHOD AND DEVICE**

(30) Priority: 21.06.2016 CN 201610454911
(71) Applicant: ZTE Corporation, Shenzhen, Guangdong 518057 (CN)
(72) Inventor: QU, Ting, Shenzhen, Guangdong 518057 (CN); CHENG, Cuixiang, Shenzhen, Guangdong 518057 (CN)
(74) Representative: Brunazzi, Stefano
(86) International application number: PCT/CN2016/103278
(87) International publication number: WO 2017/219566

(57) **Abstract**

A charging geomagnetic interference resisting method and device are provided. In the method, a current charging state of a mobile terminal is detected (S10); in a case where the current charging state is that the mobile terminal is being charged, voltage values of multiple preset sampling points (S201, S202, S203, S204) are read (S20); voltage values of two sampling points with a maximum voltage difference value are acquired according to the voltage values of the multiple preset sampling points (S201, S202, S203, S204), and a voltage difference value of the two preset sampling points is obtained by calculation (S30); a corresponding magnetic field compensation value is acquired by calculation based on the voltage difference value (S40), a current magnetic field value of the mobile terminal is read, and the current magnetic field value and the magnetic field compensation value are superimposed to acquire a corresponding actual magnetic field value (S50). With the method and the device, a problem that a magnetic field generated by an intelligent terminal in a related technology during charging affects a geomagnetic sensor is solved, magnetic field value compensation for the intelligent terminal is implemented, and the actual magnetic field value can be acquired to avoid the interference of a charging magnetic field.

## Description

### Technical Field

The disclosure relates to the technical field of charging, and in particular to a charging geomagnetic interference resisting method and device.

### Background

In present intelligent terminals, geomagnetism has basically become a standard configuration and is mainly configured to implement applications such as an electronic compass and an aided navigation. Since a geomagnetic sensor detects a magnetic field, many magnetic devices such as an earphone, a loudspeaker and a motor may affect the geomagnetic sensor. The influence may be avoided by properly arranging placement of positions of the devices. In a case where the influence cannot be completely avoided, corresponding compensation may be performed. In addition, since current can generate the magnetic field, the existence of current also affects the geomagnetic sensor.

In a related technology, a charging process may generate interference to the geomagnetic sensor. The interference results are inconsistent mainly due to reflowing from the ground during charging, and therefore the compensation processing cannot be performed. Because the design of sub-board of many terminals at present causes the reflowing of a charging current during charging, part of the current will flow back through these metal middle frames and metal battery covers, making it difficult to achieve avoidance by arranging the positions. In addition, since this part of the reflow is mainly caused by the influence of contact of a shrapnel, grounding of conductive cloth, and grounding of conductive foam gasket, the influence on the geomagnetic sensor is different in different conditions, and therefore cannot be compensated by software. Since the middle frames of most of the terminals at present are made of metal, more and more full-metal mobile phones appear, and the entire terminal is covered with metal, it is almost impossible to find a place on a main board that is not interfered by the reflowing of charging ground.

### Summary

Some embodiments of the disclosure provide a charging geomagnetic interference resisting method and device, which may solve a problem that a magnetic field generated by an intelligent terminal in a related technology during charging affects a geomagnetic sensor.

A charging geomagnetic interference resisting method provided by an embodiment of the disclosure may include the following acts.

A current charging state of a mobile terminal is detected.

In a case where the current charging state is that the mobile terminal is being charged, voltage values of multiple preset sampling points are read.

A maximum voltage difference value between the multiple preset sampling points is acquired according to the voltage values of the multiple preset sampling points to obtain a corresponding voltage difference value.

A corresponding magnetic field compensation value is acquired by calculation based on the voltage difference value.

A current magnetic field value of the mobile terminal is read, and the current magnetic field value and the magnetic field compensation value are superimposed to acquire a corresponding actual magnetic field value.

In an exemplary embodiment, the act that the maximum voltage difference value between the multiple preset sampling points is acquired according to the voltage values of the multiple preset sampling points to obtain the corresponding voltage difference value may include the following acts.

A number of the multiple preset sampling points is determined.

In a case where the number of the multiple preset sampling points is equal to two, the corresponding voltage difference value is calculated according to the voltage values of the two preset sampling points.

In a case where the number of the multiple preset sampling points is greater than two, the maximum voltage difference value between the multiple preset sampling points is acquired to obtain the corresponding voltage difference value.

In an exemplary embodiment, the act that the voltage values of the multiple preset sampling points are read may include the following acts.

Voltage signals of the multiple preset sampling points are read.

Digital conversion processing is performed on the voltage signals of the multiple preset sampling points to acquire corresponding voltage values.

In an exemplary embodiment, the act that the current magnetic field value of the mobile terminal is read, and the current magnetic field value and the magnetic field compensation value are superimposed to acquire the corresponding actual magnetic field value may include the following acts.

The current magnetic field value of the mobile terminal is read and signal amplification processing is performed on the current magnetic field value to acquire a corresponding signal amplification magnetic field value.

The signal amplification magnetic field value and the magnetic field compensation value are superimposed to acquire the corresponding actual magnetic field value.

In an exemplary embodiment, after the act that the current charging state of the mobile terminal is detected, the method may further include the following act.

In a case where the current charging state is that the mobile terminal is not being charged, the current magnetic field value of the mobile terminal is directly read.

Another embodiment of the disclosure provides a charging geomagnetic interference resisting device, which may include a detection module, a sampling point reading module, a voltage difference value calculation module, a compensation value calculation module and a superimposing module.

The detection module is configured to detect a current charging state of a mobile terminal.

The sampling point reading module is configured to read voltage values of multiple preset sampling points in a case where the current charging state is that the mobile terminal is being charged.

The voltage difference value calculation module is configured to acquire a maximum voltage difference value between the multiple preset sampling points according to the voltage values of the multiple preset sampling points to obtain a corresponding voltage difference value.

The compensation value calculation module is configured to acquire a corresponding magnetic field compensation value by calculation based on the voltage difference value.

The superimposing module is configured to read a current magnetic field value of the mobile terminal, and superimpose the current magnetic field value and the magnetic field compensation value to acquire a corresponding actual magnetic field value.

In an exemplary embodiment, the voltage difference value calculation module is further configured to:
determine a number of the multiple preset sampling points; in a case where the number of the multiple preset sampling points is equal to two, calculate the corresponding voltage difference value according to the voltage values of the two preset sampling points; and in a case where the number of the multiple preset sampling points is greater than two, acquire the maximum voltage difference value between the multiple preset sampling points to obtain the corresponding voltage difference value.

In an exemplary embodiment, the sampling point reading module is further configured to:
read voltage signals of the multiple preset sampling points; and perform digital conversion processing on the voltage signals of the multiple preset sampling points to acquire corresponding voltage values.

In an exemplary embodiment, the superimposing module is further configured to:
read the current magnetic field value of a mobile terminal and perform signal amplification processing on the current magnetic field value to acquire a corresponding signal amplification magnetic field value; and superimpose the signal amplification magnetic field value and the magnetic field compensation value to acquire the corresponding actual magnetic field value.

In an exemplary embodiment, the device may further include a magnetic field value reading module.

The magnetic field value reading module is configured to directly read the current magnetic field value of the mobile terminal in a case where the current charging state is that the mobile terminal is not being charged.

In an embodiment of the disclosure, a computer storage medium is also provided. An execution command may be stored in the computer storage medium and is configured to execute implementations of the charging geomagnetic interference resisting method in the abovementioned embodiments.

The embodiments of the disclosure provide a charging geomagnetic interference resisting method and device. In the method, a current charging state of a mobile terminal is detected; in a case where the current charging state is that the mobile terminal is being charged, voltage values of multiple preset sampling points are read; a maximum voltage difference value between the multiple preset sampling points is acquired according to the voltage values of the multiple preset sampling points to obtain a corresponding voltage difference value; a corresponding magnetic field compensation value is acquired by calculation based on the voltage difference value; and a current magnetic field value of the mobile terminal is read, and the current magnetic field value and the magnetic field compensation value are superimposed to acquire a corresponding actual magnetic field value.

By virtue of the solution, a problem that a magnetic field generated by an intelligent terminal in a related technology during charging affects a geomagnetic sensor is solved. Magnetic field value compensation for the intelligent terminal is implemented, and the actual magnetic field value can be acquired to avoid the interference of a charging magnetic field.

### Brief Description of the Drawings

Fig. 1 is a flow schematic diagram of a charging geomagnetic interference resisting method according to a first embodiment of the disclosure.
Fig. 2 is an implementation block diagram of a charging geomagnetic interference resisting method according to an embodiment of the disclosure.
Fig. 3 is a flow schematic diagram of acquiring a maximum voltage difference value between sampling points according to voltage values of multiple preset sampling points to obtain a corresponding voltage difference value according to an embodiment of the disclosure.
Fig. 4 is a flow schematic diagram of reading voltage values of multiple preset sampling points according to an embodiment of the disclosure.
Fig. 5 is a flow schematic diagram of reading a current magnetic field value of a mobile terminal, and superimposing the current magnetic field value and a magnetic field compensation value to acquire a corresponding actual magnetic field value according to an embodiment of the disclosure.
Fig. 6 is a flow schematic diagram of a charging geomagnetic interference resisting method according to a second embodiment of the disclosure.
Fig. 7 is a schematic diagram showing functional modules in a charging geomagnetic interference resisting device according to a first embodiment of the disclosure.
Fig. 8 is a schematic diagram showing functional modules in a charging geomagnetic interference resisting device according to a second embodiment of the disclosure.

The implementation, functional characteristics and advantages of the disclosure will be further described with reference to the accompanying drawings in combination with the embodiments.

### Detailed Description of the Embodiments

It shall be understood that the specific embodiments described herein are merely used for illustrating the disclosure instead of limiting the disclosure.

A solution adopted in some embodiments of the disclosure is described as follows. A current charging state of a mobile terminal is detected; in a case where the current charging state is that the mobile terminal is being charged, voltage values of multiple preset sampling points are read; a maximum voltage difference value between the multiple preset sampling points is acquired according to the voltage values of the multiple preset sampling points to obtain a corresponding voltage difference value; a corresponding magnetic field compensation value is acquired through calculation based on the voltage difference value; and a current magnetic field value of the mobile terminal is read, and the current magnetic field value and the magnetic field compensation value are superimposed to acquire a corresponding actual magnetic field value.

By virtue of the solution, a problem that a magnetic field generated by an intelligent terminal in a related technology during charging affects a geomagnetic sensor is solved. Magnetic field value compensation for the intelligent terminal is implemented, and the actual magnetic field value can be acquired to avoid the interference of a charging magnetic field.

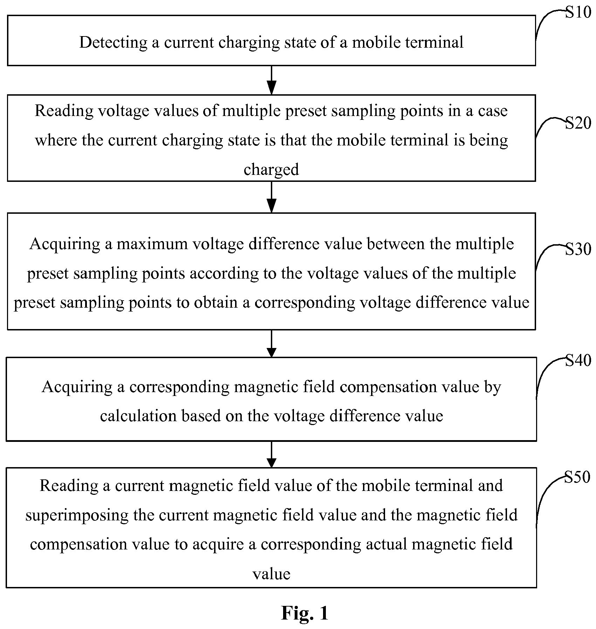

As shown in Fig. 1, a charging geomagnetic interference resisting method provided by an embodiment of the disclosure may include the following acts S10 to S 50.

At act S10, a current charging state of a mobile terminal is detected.

An executive body for the method in the first embodiment of the disclosure may be a mobile phone or a mobile terminal. The embodiment takes the mobile terminal as an example, and this should not be deemed to exclude other devices or apparatuses that are capable of implementing charging magnetic field interference resisting.

In this embodiment, the mobile terminal detects the current charging state of the mobile terminal to check whether the mobile terminal is being charged.

At act S20, in a case where the current charging state is that the mobile terminal is being charged, voltage values of multiple preset sampling points are read.

After the current charging state of the mobile terminal is detected, in a case where the current charging state is that the mobile terminal is being charged, the mobile terminal reads the voltage values of the multiple preset sampling points.

When the mobile terminal is being charged, it is possible to cause interference to a geomagnetic sensor of the mobile terminal due to the reflow of the ground during charging.

The mobile terminal reads voltage values of multiple sampling points in proximity to a geomagnetic sensor of the mobile terminal.

At act S30, a maximum voltage difference value between the multiple preset sampling points is acquired according to the voltage values of the multiple preset sampling points to obtain a corresponding voltage difference value.

In the embodiment, after the voltage values of the multiple preset sampling points are read, the mobile terminal acquires the maximum voltage difference value between the multiple preset sampling points according to the voltage values of the multiple preset sampling points to obtain the corresponding voltage difference value.

The mobile terminal calculates a voltage difference according to the read voltage values of the multiple preset sampling points. In a case where there are only two sampling points, the difference may be directly calculated. In a case where there are more than two sampling points, the voltage difference between two sampling points with maximum difference values is calculated.

At act S40, a corresponding magnetic field compensation value is acquired by calculation based on the voltage difference value.

In the embodiment, after the maximum voltage difference value between the multiple preset sampling points is acquired according to the voltage values of the multiple preset sampling points to obtain a corresponding voltage difference value, the corresponding magnetic field compensation value is acquired by calculation based on the voltage difference value.

The mobile terminal may calculate the magnetic field compensation value needed by a magnetic field according to the calculated voltage difference value.

Because the size of the magnetic field is in direct proportion to an electric current and therefore is also in direct proportion to a voltage, the magnetic field compensation value for the magnetic field is in linear relation with the voltage difference value.

At act S50, a current magnetic field value of the mobile terminal is read, and the current magnetic field value and the magnetic field compensation value are superimposed to acquire a corresponding actual magnetic field value.

In the embodiment, after the corresponding magnetic field compensation value is acquired by calculation based on the voltage difference value, the mobile terminal reads the current magnetic field value of the mobile terminal and superimposes the current magnetic field value and the magnetic field compensation value to acquire the corresponding actual magnetic field value.

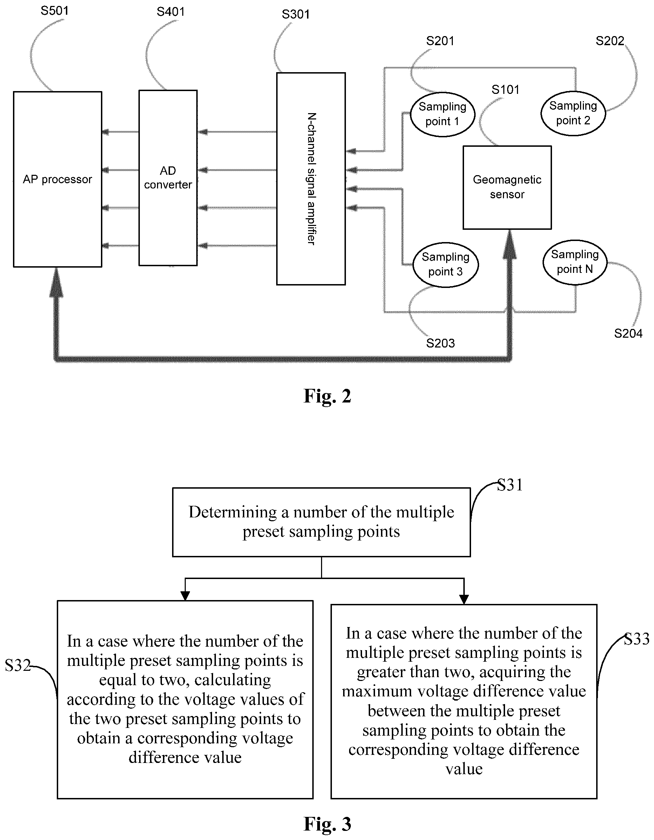

As shown in Fig. 2, in specific implementation, the following solution may be adopted.

A mobile terminal is provided with a geomagnetic sensor S101, ground sampling points S201, S202, S203 and S204 arranged in proximity to the geomagnetic sensor, a signal amplifier S301, an Analog-to-Digital (AD) conversion circuit S401 and an Application Processor (AP) S501.

The geomagnetic sensor S101 is configured to receive a signal of a magnetic field around a chip configured to determine the orientation of a direction. The ground sampling points S201, S202, S203 and S204 are configured to sample voltage values on ground signals on the vicinity of a geomagnetic chip during charging process. The signal amplifier S301 is configured to amplify the ground signal to facilitate subsequent AD conversion. The AD converter S401 is configured to convert the received voltage signal into a digital signal and is configured by the AP to process the signal. The AP processor S501 is configured to communicate with the geomagnetic sensor S101, including configuration of the geomagnetic sensor S101 and reading of data of the geomagnetic sensor S101. The AP processor S501 is further configured to receive a digital signal transmitted by the AD converter S401 and converted according to voltages of the multiple preset sampling points, and calculate the voltage difference between the multiple preset sampling points. Because the impedance at two ends of the multiple preset sampling points of a main board is constant in a case that a main-board is determined, the voltage and current at both ends of the multiple preset sampling points are in linear relation, so that the AP processor performs corresponding magnetic field compensation according to the calculated voltage difference, thereby acquiring the correct orientation of the mobile terminal.

Through the above charging geomagnetic interference resisting method provided in the embodiment of the disclosure, a problem that a magnetic field generated by an intelligent terminal in a related technology during charging affects a geomagnetic sensor can be solved. Magnetic field value compensation for the intelligent terminal can be implemented, and the actual magnetic field value can be acquired to avoid the interference of the charging magnetic field.

Further, in order to better avoid the interference of the charging magnetic field, Fig. 3 is referred, which is a flow schematic diagram of acquiring a maximum voltage difference value between sampling points according to voltage values of multiple preset sampling points to obtain a corresponding voltage difference value in a specific implementation of the disclosure.

As an implementation, the abovementioned act S30 may include the following acts S31 to S33.

At act S31, a number of the multiple preset sampling points is determined.

In the embodiment, after the voltage values of the multiple preset sampling points are read, the mobile terminal determines the number of the multiple preset sampling points.

At act S32, in a case where the number of the multiple preset sampling points is equal to two, the corresponding voltage difference value is calculated according to the voltage values of the two preset sampling points.

In the embodiment, after the number of the multiple preset sampling points is determined, in a case where the number of the multiple preset sampling points is equal to two, the mobile terminal performs calculation based on the voltage values of the two preset sampling points to obtain the corresponding voltage difference value.

In a case where two sampling points are to be configured, a suggested solution is to select two sampling points at the vicinity of a diagonal of a geomagnetic chip. For example, one of the two sampling points is close to one side of a charging chip, and the other of the two sampling points is located on a connection line of a grounding point at an outer side of the connection line from the charging chip to the geomagnetic sensor. The purpose of the arrangement of the two sampling points is to find a main path through which the reflowing ground passes. In this case, the voltage difference on the reflowing path is maximized, and the detection accuracy may be improved.

At act S33, in a case where the number of the multiple preset sampling points is greater than two, the maximum voltage difference value between the multiple preset sampling points is acquired to obtain the corresponding voltage difference value.

In the embodiment, after the number of the multiple preset sampling points is determined, in a case where the number of the multiple preset sampling points is greater than two, the mobile terminal acquires the maximum voltage difference value between the multiple preset sampling points to obtain the corresponding voltage difference value.

In order to enhance the judgment, more detection points (i.e., sampling points) may be arranged around the geomagnetic chip. The detection points may be led to a signal amplifier through a relatively thin ground wire or a 0-ohm resistor in series connection.

Through the charging geomagnetic interference resisting method provided in the embodiment of the disclosure, a problem that a magnetic field generated by an intelligent terminal in a related technology during charging affects a geomagnetic sensor can be better solved. Magnetic field value compensation of the intelligent terminal can be implemented, and the actual magnetic field value can be acquired to avoid the interference of the charging magnetic field.

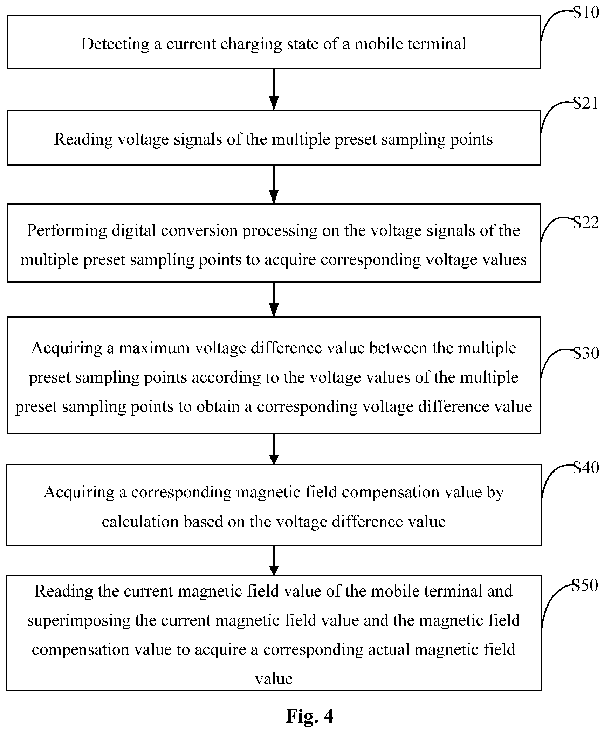

Further, in order to better avoid the interference of a charging magnetic field, Fig. 4 is referred, which is a flow schematic diagram of an act of reading voltage values of the multiple preset sampling points in an embodiment of the disclosure.

As an implementation, the above act S20 may include the following acts S21 and S22.

At act S21, voltage signals of the multiple preset sampling points are read.

In the embodiment, after a current charging state of a mobile terminal is detected, the mobile terminal reads the voltage signals of the multiple preset sampling points.

At act S22, digital conversion processing is performed on the voltage signals of the multiple preset sampling points to acquire corresponding voltage values.

In the embodiment, after voltage signals of the multiple preset sampling points are read, the mobile terminal performs digital conversion processing on the voltage signals of the multiple preset sampling points to acquire the corresponding voltage values.

Through the charging geomagnetic interference resisting method provided in the embodiment of the disclosure, a problem that a magnetic field generated by an intelligent terminal in a related technology during charging affects a geomagnetic sensor can be solved. Magnetic field value compensation for the intelligent terminal can be implemented, and the actual magnetic field value can be acquired to avoid the interference of the charging magnetic field.

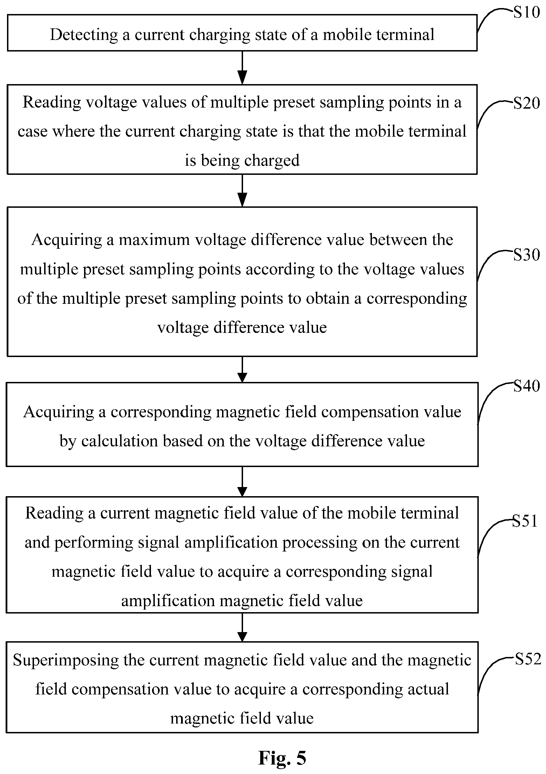

Further, in order to better avoid the interference of a charging magnetic field, Fig. 5 is referred, which is a flow schematic diagram of acts of reading a current magnetic field value of a mobile terminal and superimposing the current magnetic field value and a magnetic field compensation value to acquire a corresponding actual magnetic field value in an embodiment of the disclosure.

As an implementation, the above act S50 may include the following acts S51 and S52.

At act S51, the current magnetic field value of a mobile terminal is read and signal amplification processing is performed on the current magnetic field value to acquire a corresponding signal amplification magnetic field value.

In the embodiment, after the corresponding magnetic field compensation value is acquired by calculation based on the voltage difference value, the mobile terminal reads the current magnetic field value of the mobile terminal and performs signal amplification processing to acquire a corresponding signal amplification magnetic field value, thereby facilitating subsequent AD conversion.

At act S52, the signal amplification magnetic field value and the magnetic field compensation value are superimposed to acquire the corresponding actual magnetic field value.

In the embodiment, after the current magnetic field value of the mobile terminal is read and signal amplification processing is performed on the current magnetic field value to acquire the corresponding signal amplification magnetic field value, the mobile terminal superimposes the signal amplification magnetic field value and a magnetic field compensation value to acquire the corresponding actual magnetic field value.

Through the charging geomagnetic interference resisting method provided in the embodiment of the disclosure, a problem that a magnetic field generated by an intelligent terminal in a related technology during charging affects a geomagnetic sensor can be solved. Magnetic field value compensation for the intelligent terminal can be implemented, and the actual magnetic field value can be acquired to avoid the interference of the charging magnetic field.

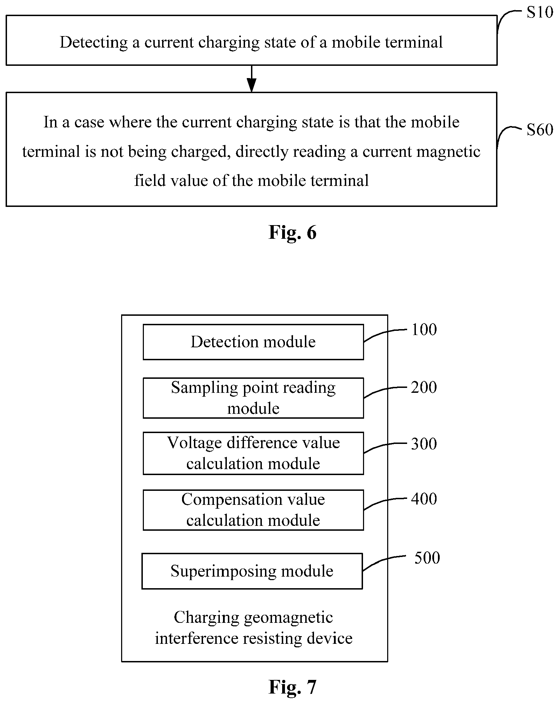

As shown in Fig. 6, a second embodiment of the disclosure provides a charging geomagnetic interference resisting method, after the act S10 of the abovementioned first embodiment, the method may further include the following act S60.

At act S60, in a case where the current charging state is that the mobile terminal is not being charged, the current magnetic field value of the mobile terminal is directly read.

In the embodiment, after the current charging state of the mobile terminal is detected, in a case where the current charging state is that the mobile terminal is not being charged, the mobile terminal directly reads a current magnetic field value of the mobile terminal.

When the mobile terminal is not charged, there is no charging magnetic field interference, the current magnetic field value of the mobile terminal can be directly read to serve as an actual magnetic field value.

Through the charging geomagnetic interference resisting method provided in the embodiment of the disclosure, a problem that a magnetic field generated by an intelligent terminal in a related technology during charging affects a geomagnetic sensor can be better solved. Magnetic field value compensation for the intelligent terminal can be implemented, and the actual magnetic field value can be acquired to avoid the interference of the charging magnetic field.

Based on the implementation of the abovementioned charging geomagnetic interference resisting method, the disclosure further provides embodiments of a corresponding device.

As shown in Fig. 7, a first embodiment of the disclosure provides a charging geomagnetic interference resisting device, which may include a detection module 100, a sampling point reading module 200, a voltage difference value calculation module 300, a compensation value calculation module 400, and a superimposing module 500.

The detection module 100 is configured to detect a current charging state of a mobile terminal.

In the embodiment, the detection module 100 detects the current charging state of the mobile terminal and detects whether the mobile terminal is being charged.

The sampling point reading module 200 is configured to read voltage values of multiple preset sampling points in a case where the current charging state is that the mobile terminal is being charged.

In the embodiment, after the current charging state of the mobile terminal is detected, in a case where the current charging state is that the mobile terminal is being charged, the sampling point reading module 200 reads the voltage values of the multiple preset sampling points.

When the mobile terminal is being charged, it is possible to cause interference to a geomagnetic sensor of the mobile terminal due to the reflowing of the ground during charging.

The mobile terminal reads the voltage values of multiple sampling points in proximity to the geomagnetic sensor of the mobile terminal.

The voltage difference value calculation module 300 is configured to acquire a maximum voltage difference value between the multiple preset sampling points according to the voltage values of the multiple preset sampling points to obtain a corresponding voltage difference value.

In the embodiment, after the voltage values of the multiple preset sampling points are read, the voltage difference value calculation module 300 is configured to acquire the maximum voltage difference value between the multiple preset sampling points according to the voltage values of the multiple preset sampling points to obtain a corresponding voltage difference value.

The mobile terminal calculates the voltage difference according to the read voltage values of the sampling points. In a case where there are only two sampling points, the difference may be directly calculated. In a case where there are more than two sampling points, the voltage difference between two sampling points with maximum difference values is calculated.

The compensation value calculation module 400 is configured to acquire a corresponding magnetic field compensation value by calculation based on the voltage difference value.

In the embodiment, the compensation value calculation module 400 is configured to, after the maximum voltage difference between the multiple preset sampling points is acquired according to the preset voltage values of multiple sampling points to obtain the corresponding voltage difference value, acquire the corresponding magnetic field compensation value by calculation based on the voltage difference value.

The mobile terminal may calculate the magnetic field compensation value needed by a magnetic field according to the calculated voltage difference value.

Because the size of the magnetic field is in direct proportion to an electric current and therefore is also in direct proportion to a voltage, the magnetic field compensation value for the magnetic field is in linear relation with the voltage difference value.

The superimposing module 500 is configured to read a current magnetic field value of the mobile terminal, and superimpose the current magnetic field value and the magnetic field compensation value to acquire a corresponding actual magnetic field value.

In the embodiment, the superimposing module 500 is configured to, after the corresponding magnetic field compensation value is acquired by calculation based on the voltage difference value, read the current magnetic field value of the mobile terminal, and superimpose the current magnetic field value and the magnetic field compensation value to acquire a corresponding actual magnetic field value.

Through the charging geomagnetic interference resisting solution provided in the embodiment of the disclosure, a problem that a magnetic field generated by an intelligent terminal in a related technology during charging affects a geomagnetic sensor can be better solved. Magnetic field value compensation for the intelligent terminal can be implemented, acquires the actual magnetic field value and avoids the interference of the charging magnetic field.

Further, in order to better avoid the interference of a charging magnetic field, as an implementation, the abovementioned voltage difference value calculation module 300 is further configured to determine a number of the multiple preset sampling points; in a case where the number of the multiple preset sampling points is equal to two, calculate the corresponding voltage difference value according to the voltage values of the two preset sampling points; and in a case where the number of the multiple preset sampling points is greater than two, acquire the maximum voltage difference value between the multiple preset sampling points to obtain the corresponding voltage difference value.

In the embodiment, after the voltage values of the multiple preset sampling points are read, the mobile terminal determines a number of the multiple preset sampling points.

After the number of the multiple preset sampling points is determined, in a case where the number of the multiple preset sampling points is equal to two, the mobile terminal calculates according to the voltage values of the two preset sampling points to obtain the corresponding voltage difference value.

In a case where two sampling points are to be configured, a suggested solution is to select two sampling points at the vicinity of a diagonal of a geomagnetic chip. For example, one of the two sampling points is close to one side of a charging chip, and the other of the two sampling points is located on a connection line of a grounding point at an outer side of the connection line from the charging chip to the geomagnetic sensor. The purpose of the arrangement of the two sampling points is to find a main path through which the reflowing ground passes. In this case, the voltage difference on the reflowing path is maximized, and the detection accuracy may be improved.

After the number of the multiple preset sampling points is determined, in a case where the number of the multiple preset sampling points is greater than two, the mobile terminal acquires the maximum voltage difference value between the multiple preset sampling points to obtain the corresponding voltage difference value.

In order to enhance the judgment, more detection points (i.e., sampling points) may be arranged around the geomagnetic chip. The detection points may be led to a signal amplifier through a relatively thin ground wire or a 0-ohm resistor in series connection.

Through the charging geomagnetic interference resisting device provided in the embodiment of the disclosure, a problem that a magnetic field generated by an intelligent terminal in a related technology during charging affects a geomagnetic sensor can be better solved. Magnetic field value compensation of the intelligent terminal can be implemented, and the actual magnetic field value can be acquired to avoid the interference of the charging magnetic field.

Further, in order to better avoid the interference of a charging magnetic field, as an implementation, the abovementioned sampling point reading module 200 is further configured to read voltage values of multiple preset sampling points, and perform digital conversion processing on the voltage signals of the multiple preset sampling points to acquire corresponding voltage values.

In the embodiment, after the current charging state of the mobile terminal is detected, the mobile terminal reads the voltage signals of the multiple preset sampling points.

After voltage signals of the multiple preset sampling points are read, the mobile terminal performs digital conversion processing on the voltage signals of the multiple preset sampling points to acquire the corresponding voltage values.

Through the charging geomagnetic interference resisting device provided in an embodiment of the disclosure, a problem that a magnetic field generated by an intelligent terminal in a related technology during charging affects a geomagnetic sensor can be better solved. Magnetic field value compensation of the intelligent terminal can be implemented, and the actual magnetic field value can be acquired to avoid the interference of the charging magnetic field.

Further, in order to better avoid the interference of a charging magnetic field, as an implementation, the abovementioned superimposing module 500 is further configured to read a current magnetic field value of a mobile terminal and perform signal amplification processing on the current magnetic field value to acquire a corresponding signal amplification magnetic field value; and superimpose the signal amplification magnetic field value and the magnetic field compensation value to acquire the corresponding actual magnetic field value.

In the embodiment, after the corresponding magnetic field compensation value is acquired by calculation according to a voltage difference value, the mobile terminal reads the current magnetic field value of the mobile terminal and performs signal amplification processing to acquire a corresponding signal amplification magnetic field value, thereby facilitating subsequent AD conversion.

After the current magnetic field value of the mobile terminal is read and signal amplification processing is performed on the current magnetic field value to acquire a corresponding signal amplification magnetic field value, the mobile terminal superimposes the signal amplification magnetic field value and the magnetic field compensation value to acquire the corresponding actual magnetic field value.

Through the charging geomagnetic interference resisting device provided in the embodiment of the disclosure, a problem that a magnetic field generated by an intelligent terminal in a related technology during charging affects a geomagnetic sensor can be better solved. Magnetic field value compensation of the intelligent terminal can be implemented, and the actual magnetic field value can be acquired to avoid the interference of the charging magnetic field.

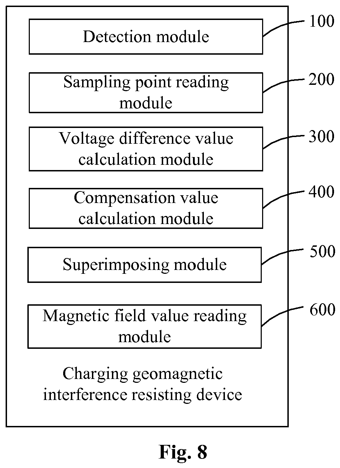

As shown in Fig. 8, a second embodiment of the disclosure provides a charging geomagnetic interference resisting device. On the basis of the above first embodiment, the device may further include a magnetic field value reading module 600.

The magnetic field value reading module 600 is configured to directly read the current magnetic field value of the mobile terminal in a case where the current charging state is that the mobile terminal is not being charged.

In the embodiment, after the current charging state of the mobile terminal is detected, in a case where the current charging state is that the mobile terminal is not being charged, the magnetic field value reading module 600 directly reads the current magnetic field value of the mobile terminal.

When the mobile terminal is not charged, there is no charging magnetic field interference, the current magnetic field value of the mobile terminal can be directly read to serve as an actual magnetic field value.

Through the charging geomagnetic interference resisting device provided in the embodiment of the disclosure, a problem that a magnetic field generated by an intelligent terminal in a related technology during charging affects a geomagnetic sensor can be better solved. Magnetic field value compensation for the intelligent terminal can be implemented, and the actual magnetic field value can be acquired to avoid the interference of the charging magnetic field.

The above is only the exemplary embodiments of the disclosure and is not intended to limit the patent scope of the disclosure. Equivalent structures or equivalent flow transformations made using the specification and the contents of accompanying drawings of the disclosure and directly or indirectly applied to other related technical fields shall fall within the scope of protection of the disclosure.

### Industrial Applicability

The above technical solution provided by the embodiments of the disclosure may be applied to a charging geomagnetic interference resisting process. A current charging state of a mobile terminal is detected. In a case where the current charging state is that the mobile terminal is being charged, voltage values of multiple preset sampling points are read. A maximum voltage difference value between the multiple preset sampling points is acquired according to the voltage values of the multiple preset sampling points to obtain a corresponding voltage difference value. A corresponding magnetic field compensation value is acquired by calculation based on the voltage difference value. A current magnetic field value of the mobile terminal is read, and the current magnetic field value and the magnetic field compensation value are superimposed to acquire a corresponding actual magnetic field value. By virtue of the solution, a problem that a magnetic field generated by an intelligent terminal in a related technology during charging affects a geomagnetic sensor is solved, magnetic field value compensation for the intelligent terminal is implemented, and the actual magnetic field value can be acquired to avoid the interference of the charging magnetic field.

## Claims

1. A charging geomagnetic interference resisting method, comprising:
detecting a current charging state of a mobile terminal,
in a case where the current charging state is that the mobile terminal is being charged, reading voltage values of multiple preset sampling points,
acquiring a maximum voltage difference value between the multiple preset sampling points according to the voltage values of the multiple preset sampling points to obtain a corresponding voltage difference value,
acquiring a corresponding magnetic field compensation value by calculation based on the voltage difference value, and
reading a current magnetic field value of the mobile terminal, and superimposing the current magnetic field value and the magnetic field compensation value to acquire a corresponding actual magnetic field value.

2. The charging geomagnetic interference resisting method as claimed in claim 1, wherein acquiring the maximum voltage difference value between the multiple preset sampling points according to the voltage values of the multiple preset sampling points to obtain the corresponding voltage difference value comprises:
determining a number of the multiple preset sampling points;
in a case where the number of the multiple preset sampling points is equal to two, calculating the corresponding voltage difference according to the voltage values of the two preset sampling points; and
in a case where the number of the multiple preset sampling points is greater than two, acquiring the maximum voltage difference value between the multiple preset sampling points to obtain the corresponding voltage difference value.

3. The charging geomagnetic interference resisting method as claimed in claim 2, wherein reading the voltage values of the multiple preset sampling points comprises:
reading the voltage signals of the multiple preset sampling points; and
performing digital conversion processing on the voltage signals of the multiple preset sampling points to acquire corresponding voltage values.

4. The charging geomagnetic interference resisting method as claimed in claim 3, wherein reading the current magnetic field value of the mobile terminal, and superimposing the current magnetic field value and the magnetic field compensation value to acquire the corresponding actual magnetic field value comprises:
reading the current magnetic field value, and performing signal amplification processing to acquire a corresponding signal amplification magnetic field value; and
superimposing the signal amplification magnetic field value and the magnetic field compensation value to acquire the corresponding actual magnetic field value.

5. The charging geomagnetic interference resisting method as claimed in claim 4, after detecting the current charging state of the mobile terminal, further comprising:
in a case where the current charging state is that the mobile terminal is not being charged, directly reading the current magnetic field value of the mobile terminal.

6. A charging geomagnetic interference resisting device, comprising:
a detection module, configured to detect a current charging state of a mobile terminal;
a sampling point reading module, configured to read voltage values of multiple preset sampling points in a case where the current charging state is that the mobile terminal is being charged;
a voltage difference value calculation module, configured to acquire a maximum voltage difference value between the multiple preset sampling points according to the voltage values of the multiple preset sampling points to obtain a corresponding voltage difference value;
a compensation value calculation module, configured to acquire a corresponding magnetic field compensation value by calculation based on the voltage difference value; and
a superimposing module, configured to read a current magnetic field value of the mobile terminal and superimpose the current magnetic field value and the magnetic field compensation value to acquire a corresponding actual magnetic field value.

7. The charging geomagnetic interference resisting device as claimed in claim 6, wherein the voltage difference value calculation module is further configured to:
determine a number of the multiple preset sampling points; in a case where the number of the multiple preset sampling points is equal to two, calculate the corresponding voltage difference value according to the voltage values of the two preset sampling points; in a case where the number of the multiple preset sampling points is greater than two, acquire the maximum voltage difference value between the multiple preset sampling points to obtain the corresponding voltage difference value.

8. The charging geomagnetic interference resisting device as claimed in claim 7, wherein the sampling point reading module is further configured to:
read voltage signals of the multiple preset sampling points, and perform digital conversion processing on the voltage signals of the multiple preset sampling points to acquire corresponding voltage values.

9. The charging geomagnetic interference resisting device as claimed in claim 8, wherein the superimposing module is further configured to:
read the current magnetic field value of the mobile terminal and perform signal amplification processing on the current magnetic field value to acquire a corresponding signal amplification magnetic field value; and superimpose the signal amplification magnetic field value and the magnetic field compensation value to acquire the corresponding actual magnetic field value.

10. The charging geomagnetic interference resisting device as claimed in claim 8, further comprising:
a magnetic field value reading module, configured to directly read the current magnetic field value of the mobile terminal in a case where the current charging state is that the mobile terminal is not being charged.
